# EUROPÄISCHE PATENTANMELDUNG

(11) **EP 1 800 792 A1**
(43) Veröffentlichungstag der Anmeldung: **27.06.2007**
(21) Anmeldenummer: 06026249.0
(22) Anmeldetag: 19.12.2006
(51) Int. Cl.: B23K 26/42, B23K 26/40, C03B 33/09, C03B 33/10

(54) **Verfahren und Vorrichtung zum Trennen mittels laser von Scheiben aus sprödem Material, insbesondere von Wafern**

(30) Priorität: 21.12.2005 DE 102005062230
(71) Anmelder: JENOPTIK Automatisierungstechnik GmbH, 07745 Jena (DE)
(72) Erfinder: Zühlke, Hans-Ulrich, Dr., 07743 Jena (DE); Grieger, Jan, 07743 Jena (DE); Eberhardt, Gabriele, 07749 Jena (DE)
(74) Vertreter: Schaller, Renate

(57) **Zusammenfassung**

Die Erfindung betrifft ein Verfahren bei dem Scheiben, insbesondere Wafer, aus einem spröden Material durch das Einbringen von thermischen Spannungen mittels Laser entlang geplanter Trennlinien getrennt werden.

Der hierfür erforderliche Temperaturgradient und die sich daraus ergebenden Druck- und Zugspannungen werden erzeugt, indem die Scheibe zuerst von ihrer Unterseite her wenigstens entlang der geplanten Trennlinien bis zur Oberseite der Scheibe hin durchkühlt wird und anschließend die Oberseite der Scheibe entlang der geplanten Trennlinie mit einem Laserstrahl beaufschlagt wird.

Beschrieben wird auch eine Vorrichtung zur Durchführung des Verfahrens.

## Beschreibung

Es ist bekannt Scheiben aus einem spröden Material, wie Glas, Keramik, Silizium, Quarz, Galliumarsenid oder Saphir, mittels Laser durch das Induzieren thermischer Spannungen zu trennen.

Wesentlich dafür, dass die Trennkante exakt entlang dem geplanten Linienverlauf entsteht (nachfolgend als Präzision der Trennlinie bezeichnet) ist, dass das durch einen ausreichend hohen Temperaturgradienten bewirkte Spannungsfeld möglichst präzise auf die geplante Trennkante lokalisiert wird.

Aus der DE 693 04 194 T2 ist ein solches Verfahren bekannt, bei dem ein Strahlungsbündel auf der Oberfläche entlang einer gewünschten Trennlinie relativ zum Werkstück bewegt wird, gefolgt von einem Kühlmittelstrahl (Wasser-LuftGemisch), der mit einem Abstand zum Auftreffpunkt des Strahlungsbündels scharf lokalisiert auf einen Punkt der erhitzen Trennlinie gerichtet wird.

Die Energie des Strahlungsbündels wird wie grundsätzlich bei allen Verfahren, bei denen mittels Laserstrahlung Spannungen induziert werden, die zur Rissbildung führen so gesteuert, dass das Volumen im Oberflächenbereich des Werkstückes, unter Beachtung hierfür relevanter Verfahrens- und Werkstückparameter, auf eine Temperatur unterhalb des Erweichungspunktes des Materials erwärmt wird, um hohe Druckspannungen im Volumen zu erzeugen.

Um einen hohen Energieeintrag bei hoher Geschwindigkeit zu erreichen, wird vorgeschlagen den Strahlfleck des Strahlungsbündels elliptisch auszubilden, wobei bereits hier erkannt wurde, dass eine signifikanter Verengung der Heizzone quer zur Schneidrichtung die Schneidpräzision steigert.

Gleichzeitig wurde erkannt, dass bedingt durch die begrenzte Einwirkzeit und die Strahlflecklänge eine Mindestbreite des Strahlfleckes notwendig ist, um die erforderlichen Druckspannungen zu bewirken.

Als optimale Werte für die Querausdehnung wird das 0,2 bis 2,0-fache der Materialdicke angegeben.

Zum Querschnitt des Kühlmittelstrahles werden in der DE 693 04 194 T2 keine Aussagen getroffen. Erfahrungsgemäß hat ein solcher Kühlmittelstrahl einen Durchmesser von 1 - 2 mm².

Gemäß einem Ausführungsbeispiel der DE 693 04 194 T2 können mit dem hier beschriebenen Verfahren, z.B. aus 1,2 mm starkem Tafelglas, Scheiben mit einem Durchmesser von 31,2 mm geschnitten werden.

Praktische Versuche haben gezeigt, dass mit diesem Verfahren beim Trennen einer Scheibe in sehr schmale Streifen oder Chips, z.B. kleiner 500 µm, die erreichbare Präzision der Trennkanten unzureichend ist.

Aus dem Kurzauszug der WO 03/018276 A1 ist ebenfalls ein Verfahren zum Trennen von brüchigem Material bekannt, bei dem ein Laserstrahl entlang einer geplanten Trennlinie auf der Oberfläche eines Werkstückes relativ bewegt wird. Gleichzeitig wird die gesamte Oberfläche von einem Kühlmittelfilm bedeckt, in welchem am jeweiligen Auftreffpunkt des Laserstrahles mittels eines Gasstromes ein Loch erzeugt wird. Entsprechend dem Laserstrahl muss die Sprühposition des Gases ebenfalls entlang der Trennlinie bewegt werden.

Im Unterschied zur DE 693 04 194 T2 werden durch die ganzflächige Oberflächenkühlung während der Bestrahlung mittels Laser zuerst an der Oberfläche Zugspannungen erzeugt und zwar nicht lokal begrenzt, sondern homogen verteilt über die gesamte Werkstückoberfläche. Die Ausbildung des Trennrisses erfolgt unmittelbar mit der Beaufschlagung der Laserstrahlung und nicht nach einer zeitlichen Verzögerung bedingt durch den Versatz zwischen dem Auftreffen des Strahlungsbündels und dem Kühlmittelstrahls wie bei der DE 693 04 194 T2. Die Zone der entstehenden Druckspannungen, bewirkt durch den Energieeintrag über die Laserstrahlung, ist folglich schmaler, als mit einem Verfahren entsprechend der erst genannten Schrift überhaupt erreichbar ist. Da keine Zeit zur Wärmeleitung gegeben ist, ist auch der entstehende Temperaturgradient nicht nur stärker auf die Trennlinien konzentriert, sondern auch höher. Die erreichbare Präzision der Schnittkanten wird damit verbessert, was insbesondere für eine Trennung in sehr kleine Einzelteile von Interesse ist.

Nachteilig an einem Verfahren gemäß WO 03/018276 ist, dass auch hier ein flüssiges Kühlmittel zwingend benötigt wird. Gegenüber einem abtragenden Trennverfahren mittels Laser hat ein Trennverfahren basierend auf dem Einbringen thermischer Spannungen den Vorteil, dass grundsätzlich keine Abprodukte entstehen, wodurch es zu keiner Verschmutzung der Werkstückoberfläche kommt. Dieser Vorteil wird natürlich zunichte gemacht, wenn wie bei den beiden beschriebenen Verfahren ein flüssiges Kühlmittel mit der Werkstückoberfläche in Kontakt kommt.

Gerätetechnisch bedarf es zusätzlich nicht nur technischer Mittel um den Kühlflüssigkeitsfilm aufzutragen, zu halten und zu entfernen, sondern auch Mittel zum Erzeugen und Führen eines Gasstromes über das Werkstück.

Gegenüber einem Verfahren nach DE 693 04 194 T2 hat ein Verfahren nach WO03/018276 auch den Nachteil, dass sich sowohl die Zug- als auch die Druckspannungen nur an der Oberfläche ausbilden und der Trennriss daher häufig als Blindriss im Volumen des Materials endet.

Es ist die Aufgabe der Erfindung ein Trennverfahren auf dem Prinzip des Induzierens thermischer Spannungen mittels Laser zu finden, bei dem die zu trennende Scheibe 1 nicht mit einem flüssigen Kühlmittel in Kontakt kommt und Trennkanten hoher Präzision geschnitten werden können.

Diese Aufgabe wird für ein Verfahren gemäß dem Oberbegriff des Anspruches 1 dadurch gelöst, dass die Kühlung vor Einwirkung des Laserstrahls 5 von der Unterseite her erfolgt, indem die Auflagefläche 2 des Werkstückhalters 3 gekühlt wird und die Kühlung wenigstens solange andauert bis die Scheibe 1 über ihre Materialdicke durchgekühlt ist.

Für eine Vorrichtung wird diese Aufgabe gemäß dem Oberbegriff des Anspruches 13 dadurch gelöst, dass im Werkstückhalter 3 Mittel zur Kühlung der Auflagefläche 2 vorhanden sind.

Vorteilhafte Ausführungen der Erfindung sind jeweils in den Unteransprüchen beschrieben.

Es ist erfindungswesentlich, dass der zum Trennen einer Scheibe 1 erforderliche Temperaturgradient und die damit verbundenen Spannungen dadurch geschaffen werden, dass die Scheibe 1 zuerst wenigstens entlang der gewünschten Trennlinien von ihrer Unterseite her durchkühlt wird, bevor seitens der Oberseite die Scheibe 1 wie aus dem Stand der Technik bekannt mit einem Laserstrahl 5 entlang der Trennlinien beaufschlagt wird.
Es werden zuerst Zugspannungen wenigstens entlang der Trennlinien über die gesamte Materialdicke und anschließend Druckspannungen an der Materialoberfläche erzeugt.

Die Erhitzung der Materialoberfläche, genauer der Oberseite der Scheibe 1, entlang der gewünschten Trennlinien kann mit Strahlbreiten, z.B. wie aus DE 693 04 194 T2 bekannt, sehr eng lokalisiert auf die Trennlinien erfolgen.

Während der zeitliche Versatz zwischen Laserstrahl und Kühlmittelstrahl bei der DE 693 04 194 T2, bedingt durch einen Mindestabstand zwischen Laserstrahl und Kühlmittelstrahl, dazu führt, dass sich erstens die Erwärmungszone durch die Wärmeleitung nicht nur in die Tiefe der Scheibe sondern auch über deren Breite ausdehnt und zweitens die Temperatur entlang der Trennlinie wieder absinkt, gibt es bei dem erfindungsgemäßen Verfahren keinen Zeitversatz zwischen Wärmeeintrag und Wärmeentzug. Damit kann ein sehr hoher Temperaturgradient erzeugt werden, der in Abhängigkeit von der Strahlbreite des Laserstrahls 5 sehr eng auf die Trennlinien lokalisiert werden kann. Insbesondere für sehr dünne Scheiben 1, z.B. Saphirwafer, die sehr schnell auf die gewünschte Kühltemperatur entlang der Trennlinien durchkühlt werden können und bei denen die Schnittabstände sehr klein sind, ist das Verfahren vorteilhaft anwendbar.

Das Kühlen der auf der Auflagefläche 2 des Werkstückhalters 3 aufliegenden Unterseite der Scheibe 1 erfolgt durch Wärmeleitung zwischen der Unterseite und der gekühlten Auflagefläche 2, womit ein Wärmeentzug durch Konvektion mittels eines flüssigen Kühlmittels, wie aus DE 693 04 194 T2 und WO 03/018276 bekannt, nicht erforderlich ist und die Scheibe 1 somit nicht in direkten Kontakt mit einer Kühlflüssigkeit kommt.

Die Scheibe 1 kann technologisch bedingt für das spätere Separieren der Chips auf einer Stretchfolie 4 aufgeklebt sein, sodass die Scheibe 1 mittelbar über die Stretchfolie 4 auf die gekühlte Auflagefläche 2 aufgelegt wird. Diese sollte ohne ihre eigentliche Funktion zu beeinträchtigen möglichst dünn und gut wärmeleitfähig sein.

Die Scheibe 1 bzw. die Stretchfolie 4 kann stoff-, form-, oder kraftschlüssig auf der Auflagefläche 2 fixiert werden. Zwei in Verbindung mit einem erfindungsgemäßen Verfahren bzw. einer erfindungsgemäßen Vorrichtung vorteilhafte Möglichkeiten der Fixierung werden an späterer Stelle konkret genannt.

Ob die Scheibe 1 über die auf der Auflagefläche 2 aufliegende Oberfläche ganzflächig gekühlt wird, d.h. das gesamte Volumen der Scheibe 1 wird durchkühlt oder die Scheibe 1 nur entlang der gewünschten Trennlinie über die Scheibendicke gekühlt wird, ist im Wesentlichen eine Frage der aufzubringenden Energie, der Kühlzeit und der technischen Grenzen für eine partielle Kühlung sehr eng liegender Trennlinien.

Wenn die Kühlung vorteilhaft auch während der Einwirkung des Laserstrahls 5 stattfindet, wird der durch einen lokal begrenzten Wärmeentzug geschaffene Temperaturgradient auch durch eine Wärmeleitung innerhalb der Scheibe 1 nicht wieder verringert, sodass eine eng auf die Trennlinien begrenzte Kühlung für die Verfahrensdurchführung ausreichend ist.

Die Kühlung des gesamten Scheibenvolumens hat allerdings den Vorteil, dass über einen berührenden oder berührungsfreien Temperaturfühler die Temperatur der Scheibe 1 erfasst werden kann um die Kühlung so zu regeln, dass eine stets gleiche reproduzierbare Prozesstemperatur bei der Bearbeitung der Scheiben 1 eingestellt werden kann.

Eine Temperaturerfassung nur partiell gekühlter Bereiche stellt sich insbesondere in Anbetracht der geometrischen Dimensionen der Scheibe 1 als praktisch schwierig dar.

Eine Kühlung über die gesamte Oberfläche, z.B. durch umströmende Gase, kann auch einer Flächenkühlung oder einer lokal begrenzten, partiellen Kühlung vorangehen. Damit kann die eigentlich aktive Prozesszeit in der die Scheibe 1 auf der Auflagefläche 2 liegt, verringert werden, insbesondere für dickere Scheiben 1, bei denen eine gleichmäßige Abkühlung über die Scheibendicke aufgrund des schlecht wärmeleitenden spröden Materials relativ langsam vonstatten geht. Zu diesem Zweck können die Scheiben 1 vor dem Trennprozess kühl gelagert werden oder aber über eine vorgeordnete Kühlkammer dem Werkstückhalter 3 zugeführt werden.

Die Erfindung soll nachfolgend an hand von Ausführungsbeispielen unter zur Hilfenahme einer Zeichnung näher erläutert werden.
Hierzu zeigt:

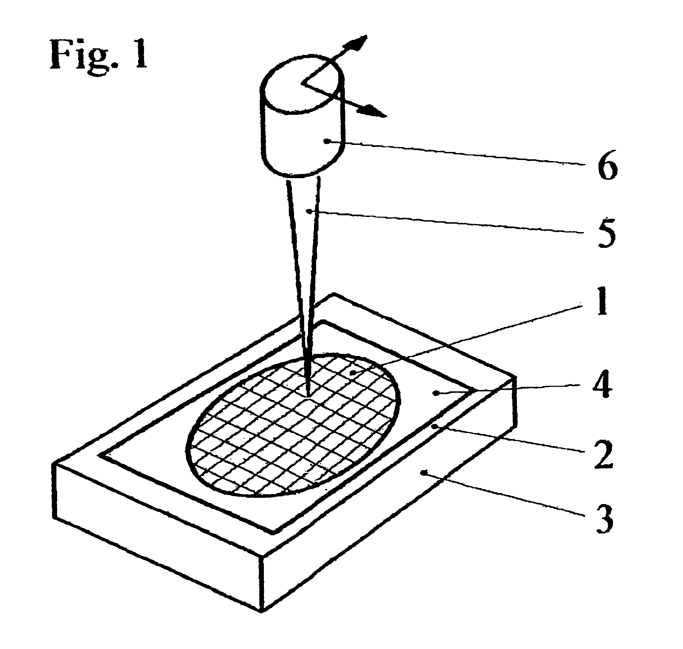

Fig. 1: eine erfindungsgemäße Vorrichtung mit ihren wesentlichen Baugruppen

In einem ersten Ausführungsbeispiel soll eine Scheibe 1, hier ein einseitig mit Bauelementen beschichteter, 90 µm dicker Saphirwafer mit einem Durchmesser von 2" in Einzelteile (Chips) z.B. mit einer Kantenlänge von 280 µm x 280 µm vereinzelt werden. D.h. das Raster der geplanten Trennlinien besteht aus zwei Gruppen von geraden Trennlinien, die jeweils in den sogenannten Gräben und zueinander in einen Abstand von nur 280 µm verlaufen wobei die Gruppen zueinander um 90° verdreht angeordnet sind.

Bevor der Saphirwafer 1 auf eine Auflagefläche 2 eines Werkstückhalters 3 platziert wird, wird er mit der beschichteten Bauelementseite auf eine Stretchfolie 4 geklebt. Sie dient dem Zusammenhalten der nach dem Trennprozess vereinzelten Chips, bevor sie durch das Dehnen der Stretchfolie 4 voneinander räumlich beabstandet werden, um sie anschließend zu entnehmen.

Nach der Auflage der mit dem Saphirwafer beklebten Stretchfolie 4 auf die Auflagefläche 2 des Werkstückhalter 3 wird die Stretchfolie 4 fixiert. Dies erfolgt in dem ersten Ausführungsbeispiel kraftschlüssig durch Ansaugen der Stretchfolie 4 auf die Auflagefläche 2. Die Auflagefläche 2 ist zu diesem Zweck aus einem porösen Material, das bevorzugt eine hohe Wärmeleitfähigkeit aufweist. Anstelle eines porösen Materials können in die Auflagefläche 2 zwischen den Gräben auch Durchbrüche zum Ansaugen vorhanden sein, insbesondere wenn die Gräben einen größeren Grabenabstand aufweisen, wie sie z.B. bei Siliziumwafern und üblichen Chipgrößen von 3 bis 10 mm gegeben sind. Unterhalb des porösen Materials bzw. der mit Durchbrüchen versehenen Auflagefläche 2 wird ein Unterdruck erzeugt, sodass die Stretchfolie 4 durch die Poren bzw. die Durchbrüche auf die Auflagefläche 2 gezogen wird. Durch das Ansaugen wird die Scheibe 1 nicht nur fixiert, sondern auch in eine Ebene gezogen, was für eine hochpräzise Trennung von Vorteil ist.

Die Kühlung der Auflagefläche 2 kann mit verschiedensten dem Fachmann bekannten Maßnahmen erfolgen. So können unterhalb der Auflagefläche 2 flüssige oder gasförmige Kühlmittel geführt werden oder aber die Auflagefläche 2 wird über Pelltierelemente gekühlt. Je nach dem, ob die Auflagefläche 2 homogen oder rasterförmig, entsprechend dem Trennlinienraster, gekühlt wird, wird die aufgelegte Scheibe 1 homogen oder eben nur entlang der Gräben in denen Trennlinien vorgesehen sind durchkühlt.

Vorteilhaft wird z.B. mittels eines Infrarotsensors die Temperatur der Scheibe 1 an ihrer Oberseite überwacht. Sobald die Temperatur auf eine vorgegebene Temperatur abgesenkt ist, beginnt der eigentliche Trennprozess indem der Laserstrahl 5 auf die Oberseite gerichtet wird. Üblicherweise werden erst alle Trennlinien einer Richtung gelasert bevor nach Drehung der Scheibe 1 die verbleibenden Trennlinien vom Laserstrahl 5 überstrichen werden. Während des eigentlichen Trennprozesses wird die Temperatur der Scheibe 1 gehalten.

Ist kein Temperatursensor vorhanden, erfolgt die Kühlung über eine bestimmte Zeit die zuvor als optimale Kühlzeit durch praktische Versuche ermittelt wurde.

In einem zweiten Ausführungsbeispiel soll die Scheibe 1, ein Siliziumwafer mit einem Durchmesser von 300 mm und einer Dicke von 200 µm sein. Der Siliziumwafer soll in Chips mit einer Kantenlänge von 10x10 mm aufgetrennt werden.

Das Fixieren und Kühlen des Siliziumwafers erfolgt hier stoffschlüssig über ein "Anfrieren" des Wafers über seine Unterseite an der Auflagefläche 2 des Werkstückhalters 3. Zu diesem Zweck sind in der Auflagefläche 2 Schlitze in einem Raster gleich der geplanten Trennlinien vorhanden, die mit einer Flüssigkeit, z.B. Wasser gefüllt werden. Nachdem der Siliziumwafer auf eine Stretchfolie 4 aufgeklebt wurde, wird die Stretchfolie 4 auf die Auflagefläche 2 so aufgelegt, dass die Gräben des Wafers auf den Schlitzen zur Auflage kommen und die Stretchfolie 4 in diesen Bereichen mit dem Wasser in Verbindung kommt. Das Wasser wird nun zum Gefrieren gebracht, wodurch die Stretchfolie 4 anfriert und somit fixiert wird. Es kann auch die gesamte Auflagefläche 2 von einem Flüssigkeitsfilm bedeckt sein, der nach Auflage der mit einer Scheibe 1 bestückten Stretchfolie 4 zum Erstarren gebracht wird.

Auch in diesem Ausführungsbeispiel wird der Wafer so lange gekühlt bis er zumindest entlang der Trennlinien auf seiner Oberseite die gewünschte Temperatur erreicht hat. Eine weitere Kühlung dient nicht mehr der weiteren Absenkung der Temperatur sondern dem Halten der abgesenkten Temperatur. Welche Temperatur hier optimal ist, damit ein ausreichend hoher Temperaturgradient erreicht wird, hängt insbesondere vom Wafermaterial und den Prozessparametern des Lasers 6 ab.

Um den eigentlichen Arbeitsprozess beginnend mit der Auflage der Scheibe 1 auf die Auflagefläche 2 möglichst kurz zu halten, kann die Scheibe 1 bereits vorgekühlt aufgelegt werden. Dazu kann die Scheibe 1 in einer Kühlkammer gelagert werden oder aber auf dem Weg zum Werkstückhalter 3 durch eine gekühlte Zone transportiert werden.

Eine erfindungsgemäße Vorrichtung weist wenigstens wie gleichartige aus dem Stand der Technik bekannte Vorrichtungen einen Laser 6 , einen Werkstückhalter 3 auf dem das Werkstück, hier eine Scheibe 1, gehalten wird und eine Bewegungseinrichtung mit der der Laserstrahl 5 zur Scheibe 1 relativ bewegt wird auf.

Unterschiedlich ist insbesondere, dass auf dem Werkstückhalter 3 die Scheibe 1 nicht nur fixiert wird, sondern die Scheibe 1 über dessen Auflagefläche 2 vor und vorteilhaft auch während des Verfahrens gekühlt wird.

Zur Kühlung können unterhalb der Auflagefläche 2 Kühlkanäle ausgebildet sein durch die ein flüssiges oder gasförmiges Kühlmittel strömt. Um die Auflagefläche 2 möglichst homogen zu kühlen, werden die Kühlkanäle möglichst dicht nebeneinander gelegt.
Für eine partielle Kühlung nur entlang den geplanten Trennlinien können die Kühlkanäle in einem Raster gleich dem Raster der geplanten Trennlinien ausgebildet werden.

Die Auflagefläche 2 selbst kann auch durch die Kühlkanäle gebildet werden. Das bei der Beschreibung der Verfahrensdurchführung beschriebene Ansaugen der Scheibe 1 auf die Auflagefläche 2 kann dann durch die zwischen den Kühlkanälen gebildeten Zwischenräume erfolgen.
Anstelle geschlossener Kühlkanäle unterhalb oder innerhalb der Auflagefläche 2 kann die Auflagefläche 2 auch eine Vielzahl von Nuten aufweisen, die in einem Raster gleich dem Trennlinienraster angeordnet sind. Diese Nuten werden mit einer Kühlflüssigkeit gefüllt, die unterhalb ihres Gefrierpunktes abgekühlt wird und so durch Stoffschluss die aufliegende Stretchfolie 4 hält und gleichzeitig die Scheibe 1 kühlt.

Wie bereits an verschiedenen Stellen erwähnt, wird die Stretchfolie 4 insbesondere benötigt um den Wafer während und nach der Separierung in einzelne Chips in der Position zu halten. Für das erfindungsgemäße Verfahren ist die Stretchfolie 4 insoweit von Vorteil, das ein Halten durch Ansaugen möglich ist und das bei einem alternativen Halten über Anfrieren die zu vereisende Kühlflüssigkeit nicht mit dem Wafer in Kontakt kommt. Das Vorhandensein einen Stretchfolie 4 zwischen der Unterseite der Scheibe 1 und der Auflagefläche 2 des Werkzeughalters 3 ist jedoch nicht zwingend für das Gelingen des Verfahrens.

### Bezugszeichenliste

- 1: Scheibe
- 2: Auflagefläche
- 3: Werkzeughalter
- 4: Stretchfolie
- 5: Laserstrahl
- 6: Laser

## Patentansprüche

1. Verfahren zum Trennen einer Scheibe (1) aus einem spröden Material, bei dem durch das Einbringen thermomechanischer Spannungen mittels Laser (6) ein Riss gebildet wird, der sich von der Oberseite der Scheibe (1) wenigstens in die Scheibe (1) hinein zur Unterseite hin und in Richtung der gewünschten Trennlinien erstreckt, indem die Scheibe (1) mit ihrer Unterseite auf eine Auflagefläche (2) eines Werkstückhalter (3) fixiert wird und ein Laserstrahl (5) auf die Oberseite der Scheibe (freie Oberfläche) entlang der gewünschten Trennlinien relativ zur Scheibe (1) bewegt wird und die Scheibe (1) entlang der gewünschten Trennlinien gekühlt wird, **dadurch gekennzeichnet,**
**dass** die Kühlung vor Einwirkung des Laserstrahls (5) von der Unterseite der Scheibe (1) her erfolgt, indem die Auflagefläche (2) des Werkstückhalters (3) gekühlt wird und die Kühlung wenigstens solange andauert bis die Scheibe (1) über ihre Materialdicke durchgekühlt ist.

2. Verfahren nach Anspruch 1, **dadurch gekennzeichnet,**
**dass** die Kühlung eng begrenzt lokalisiert entlang der gewünschten Trennlinien erfolgt.

3. Verfahren nach Anspruch 1, **dadurch gekennzeichnet,**
**dass** die Kühlung ganzflächig erfolgt.

4. Verfahren nach einem der Ansprüche 1 - 3, **dadurch gekennzeichnet,**
**dass** die Scheibe (1) mittelbar auf der Auflagefläche (2) fixiert ist.

5. Verfahren nach einem der Ansprüche 1 - 3, **dadurch gekennzeichnet,**
**dass** die Scheibe (1) unmittelbar auf der Auflagefläche (2) fixiert ist.

6. Verfahren nach Anspruch 4, **dadurch gekennzeichnet,**
**dass** die Scheibe (1) auf einer Stretchfolie (4) haftend auf der Auflagefläche (2) aufliegt.

7. Verfahren nach Anspruch 1 oder 6, **dadurch gekennzeichnet,**
**dass** die Scheibe (1) angesaugt gehalten wird.

8. Verfahren nach Anspruch 1, 5 oder 6, **dadurch gekennzeichnet,**
**dass** die Scheibe (1) durch vereiste Flüssigkeit gehalten wird.

9. Verfahren nach Anspruch 8, **dadurch gekennzeichnet,**
**dass** die Flüssigkeit einen die Auflagefläche (2) abdeckenden Film bildet.

10. Verfahren nach Anspruch 8, **dadurch gekennzeichnet,**
**dass** sich die Flüssigkeit innerhalb der Auflagefläche (2) in Nuten mit einem Raster entsprechend den gewünschten Trennlinien befindet.

11. Verfahren nach Anspruch 1, **dadurch gekennzeichnet,**
**dass** die Kühlung während der Einwirkung des Laserstrahls (5) fortgesetzt wird.

12. Verfahren nach Anspruch 1, **dadurch gekennzeichnet,**
**dass** die Scheibe (1) vor Auflage auf die Werkstückhalter (3) vorgekühlt wird.

13. Vorrichtung zur Trennung einer Scheibe (1) aus einem spröden Material, mit einem Laser (6), der einen Laserstrahl (5) auf die Oberseite der Scheibe (1) richtet, einem Werkstückhalter (3), der eine Auflagefläche (2) aufweist, auf dem die Scheibe (1) mit ihrer Unterseite aufgelegt und fixiert wird und eine Bewegungseinrichtung zur relativen Bewegung des Laserstrahls (5) entlang geplanter Trennlinien auf der Oberfläche der Scheibe (1) **dadurch gekennzeichnet,**
**dass** im Werkstückhalter (3) Mittel zur Kühlung der Auflagefläche (2) vorhanden sind.

14. Vorrichtung nach Anspruch 13, **dadurch gekennzeichnet,**
**dass** die Mittel zur Kühlung mit einem flüssigen oder gasförmigen Kühlmittel durchströmte Kühlkanäle sind, die unterhalb der Auflagefläche (2) angeordnet sind.

15. Vorrichtung nach Anspruch 13, **dadurch gekennzeichnet,**
**dass** die Mittel zur Kühlung mit einem flüssigen oder gasförmigen Kühlmittel durchströmte Kühlkanäle sind die die Auflagefläche (2) bilden.

16. Vorrichtung nach Anspruch 14 oder 15, **dadurch gekennzeichnet,**
**dass** die Kühlkanäle in einem Raster angeordnet sind gleich dem Raster der geplanten Trennlinien.

17. Vorrichtung nach Anspruch 12, **dadurch gekennzeichnet,**
**dass** Mittel zur Erzeugung eines Unterdrucks im Werkzeughalter (3) vorhanden sind und eine auf der Auflagefläche (2) aufliegende Scheibe (1) durch die zwischen den Kanälen verbleibenden Abständen angesaugt wird.

18. Vorrichtung nach Anspruch 10, **dadurch gekennzeichnet,**
**dass** die Mittel zur Kühlung mit einer vereisten Flüssigkeit in der Auflagefläche (2) gefüllte Nuten sind über die die Scheibe (1) auch an der Auflagefläche (2) fixiert ist.
